# EUROPÄISCHE PATENTSCHRIFT

(11) **EP 2 726 999 B1**
(45) Veröffentlichungstag und Bekanntmachung des Hinweises auf die Patenterteilung: **09.09.2015**
(21) Anmeldenummer: 12730927.6
(22) Anmeldetag: 26.06.2012
(51) Int. Cl.: G06F 13/42, H04L 12/413

(54) **VERFAHREN UND VORRICHTUNG ZUR SERIELLEN DATENÜBERTRAGUNG MIT FLEXIBLER NACHRICHTENGRÖSSE UND VARIABLER BITLÄNGE**
METHOD AND DEVICE FOR SERIAL DATA TRANSMISSION HAVING A FLEXIBLE MESSAGE SIZE AND A VARIABLE BIT LENGTH
PROCÉDÉ ET DISPOSITIF DE TRANSMISSION SÉRIELLE DE DONNÉES À GRANDEUR FLEXIBLE DES MESSAGES ET À LONGUEUR EN BITS VARIABLE

(30) Priorität: 29.06.2011 DE 102011078266; 29.06.2011 DE 102011122843
(43) Veröffentlichungstag der Anmeldung: 07.05.2014
(73) Patentinhaber: Robert Bosch GmbH, 70442 Stuttgart (DE)
(72) Erfinder: HARTWICH, Florian, 72762 Reutlingen (DE); HORST, Christian, 72144 Dusslingen (DE)
(86) Internationale Anmeldenummer: PCT/EP2012/062357
(87) Internationale Veröffentlichungsnummer: WO 2013/000911

(56) Entgegenhaltungen:
- US-A1- 2007 091 932
- US-A1- 2010 158 045

## Beschreibung

### Stand der Technik

Die Erfindung betrifft ein Verfahren sowie eine Vorrichtung, beispielsweise einen Kommunikationscontroller, zur seriellen Datenübertragung zwischen wenigstens zwei Teilnehmern in einem seriellen Bussystem.

Beispielsweise aus den Normen der Familie ISO 11898-1 bis -5 ist das Controller Area Network (CAN) sowie eine als "Time Triggered CAN" (TTCAN) bezeichnete Erweiterung des CAN bekannt, im Folgenden auch als Norm CAN bezeichnet. Das beim CAN verwendete Medienzugriffssteuerverfahren beruht auf einer bitweisen Arbitrierung. Bei der bitweisen Arbitrierung können mehrere Teilnehmerstationen gleichzeitig Daten über den Kanal des Bussystems übertragen, ohne dass hierdurch die Datenübertragung gestört wird. Die Teilnehmerstationen können weiterhin beim Senden eines Bits über den Kanal den logischen Zustand (0 oder 1) des Kanals ermitteln. Entspricht ein Wert des gesendeten Bits nicht dem ermittelten logischen Zustand des Kanals, dann beendet die Teilnehmerstation den Zugriff auf den Kanal. Bei CAN wird die bitweise Arbitrierung üblicherweise anhand eines Identifiers innerhalb einer über den Kanal zu übertragenden Nachricht vorgenommen. Nachdem eine Teilnehmerstation den Identifier vollständig an den Kanal gesendet hat, weiß sie, dass sie exklusiven Zugriff auf den Kanal hat. Somit entspricht das Ende der Übertragung des Identifiers einem Beginn eines Freigabeintervalls, innerhalb dessen die Teilnehmerstation den Kanal exklusiv nutzen kann. Gemäß der Protokollspezifikation des CAN dürfen andere Teilnehmerstationen so lange nicht auf den Kanal zugreifen, das heißt Daten an den Kanal senden, bis die sendende Teilnehmerstation ein Prüfsummenfeld (CRC Field) der Nachricht übertragen hat. Somit entspricht ein Endzeitpunkt der Übertragung des CRC Fields einem Ende des Freigabeintervalls.

Durch die bitweise Arbitrierung wird also eine zerstörungsfreie Übertragung derjenigen Nachricht über den Kanal erreicht, die das Arbitrierungsverfahren gewonnen hat. Die Protokolle des CAN eignen sich besonders zum Übertragen kurzer Meldungen unter Echtzeitbedingungen, wobei durch geeignete Zuweisung der Identifier sichergestellt werden kann, dass besonders wichtige Nachrichten nahezu immer die Arbitrierung gewinnen und erfolgreich gesendet werden.

Mit der zunehmenden Vernetzung moderner Fahrzeuge und dem Einzug zusätzlicher Systeme zur Verbesserung beispielsweise der Fahrsicherheit oder des Fahrkomforts wachsen die Anforderungen an die zu übertragenden Datenmengen und die bei der Übertragung zulässigen Latenzzeiten. Beispiele sind Fahrdynamikregelsysteme wie z.B. das elektronische Stabilitätsprogramm ESP, Fahrerassistenzsysteme wie z.B. die automatische Abstandsregelung ACC, oder Fahrerinformationssysteme wie z.B. die Verkehrszeichenerkennung (vgl. beispielsweise Beschreibungen in "Bosch Kraftfahrtechnisches Handbuch", 27. Auflage, 2011, Vieweg+Teubner).

DE 103 11 395 A1 beschreibt ein System, bei welchem asynchrone, serielle Kommunikation alternativ über ein asymmetrisches physikalisches oder über das symmetrische physikalische CAN-Protokoll erfolgen kann, und dadurch eine höhere Datenübertragungsrate oder -sicherheit für die asynchrone Kommunikation erzielbar ist.

DE 10 2007 051 657 A1 schlägt vor, in den exklusiven Zeitfenstern des TTCAN Protokolles eine asynchrone, schnelle, nicht CAN-konforme Datenübertragung anzuwenden, um die übertragene Datenmenge zu erhöhen.

G. Cena und A. Valenzano behandeln in "Overclocking of controller area networks" (Electronics Letters, Vol. 35, No. 22 (1999), S. 1924) die Auswirkungen einer Übertaktung der Busfrequenz in Teilbereichen der Nachrichten auf die effektiv erzielte Datenrate.

US 2010/158045 offenbart ein Verfahren gemäß dem Oberbegriff des Anspruchs 1.

Es zeigt sich, dass der Stand der Technik nicht in jeder Hinsicht befriedigende Ergebnisse liefert.

### Offenbarung der Erfindung

Im Folgenden wird die Erfindung mit ihren Vorteilen anhand von Zeichnungen und Ausführungsbeispielen beschrieben. Der Gegenstand der Erfindung ist nicht auf die dargestellten und geschilderten Ausführungsbeispiele beschränkt.

### Vorteile der Erfindung

Die vorliegende Erfindung stellt ein Verfahren zur seriellen Datenübertragung in einem Bussystem mit mindestens zwei Busteilnehmern, die über den Bus Nachrichten austauschen, bereit, wobei die gesendeten Nachrichten einen logischen Aufbau gemäß der CAN-Norm ISO 11898-1 aufweisen. Das heisst, Daten übertragende Nachrichten sind aufgebaut aus einem einzelnen führenden "Start-Of-Frame"-Bit und einer Folge von Feldern (Field) aus mehreren Bits, nämlich Arbitration Field, Control Field, Data Field, CRC Field, Acknowledge Field, und End-of-Frame Field.

Das Verfahren zeichnet sich dadurch aus, dass bei Vorliegen einer ersten Kennzeichnung das Control Field der Nachrichten abweichend von der CAN-Norm ISO 11898-1 mehr als sechs Bit umfasst, wobei bei Vorliegen der ersten Kennzeichnung das Control Field der Nachricht um wenigstens ein weiteres Bit erweitert wird, wobei durch das weitere Bit oder eines der weiteren Bits eine Information über den Zustand "Error Passive" des Busteilnehmers in versandte Botschaften integriert wird. Der Vorteil des vorgeschlagenen Verfahrens liegt darin, dass mit diesem Verfahren Busteilnehmer, die sich im Zustand "Error Passive" befinden, von den anderen Busteilnehmern eindeutig identifiziert werden können.

In einer bevorzugten Ausführungsform kann bei Vorliegen der ersten Kennzeichnung das Datenfeld der Nachrichten abweichend von der CAN-Norm ISO 11898-1 mehr als acht Bytes umfassen kann, wobei zur Feststellung der Größe des Datenfeldes die Werte der vier Bits des Data Length Codes zumindest teilweise abweichend von der CAN-Norm ISO 11898-1 interpretiert werden. In einer besonders bevorzugten Ausführungsform nimmt bei Vorliegen einer zweiten Kennzeichnung die Bitlänge für wenigstens einen vorgegebenen oder vorgebbaren Bereich innerhalb der Nachricht einen gegenüber der vor dem Vorliegen der zweiten Kennzeichnung verwendeten Bitlänge verkürzten Wert an, wobei der Bereich frühestens mit der zweiten Kennzeichnung beginnt und spätestens mit dem CRC Delimiter endet, wobei die zweite Kennzeichnung nur bei Vorliegen der ersten Kennzeichnung auftritt und in dem abweichend von der CAN-Norm ISO 11898-1 mehr als sechs Bit umfassenden Control Field der Nachrichten erfolgt. Dies hat gegenüber den aus dem Stand der Technik bekannten Verfahren den Vorteil, dass durch die zweistufige Umschaltung - einerseits der Größe des Datenfeldes und andererseits der Bitlänge in Teilen der Nachricht - mit jeweils separater Kennzeichnung die Vorteile der beiden Maßnahmen je nach Möglichkeit auch separat ausgenutzt werden können. Beispielsweise können auch dann, wenn aus Gründen der Bustopologie die Umschaltung auf kürzere Bitlänge nicht möglich ist, weiterhin Nachrichten mit einer höheren Datenmenge versendet werden. Auch kann bei Auftreten von Fehlern in Nachrichten mit verkürzter Bitlänge zunächst auf die normale Bitlänge ungeschaltet werden, ohne die Vorteile der Vergrößerung des Datenbereiches zu opfern.

Es ist besonders vorteilhaft, dass die erste Kennzeichnung (EDL) durch ein rezessives Bit im Control Field erfolgt, da dort Bits zur Verfügung stehen, welche in normgemäßen CAN Nachrichten stets dominant versendet werden. Außerdem kann die Flanke zwischen der rezessiven Kennzeichnung und einem nachfolgenden dominanten Bit für Synchonisierungszwecke genutzt werden, wenn, wie in einer vorteilhaften Ausführungsform vorgesehen, auf das rezessive Bit der ersten Kennzeichnung (EDL) in allen Daten-Nachrichten wenigstens ein dominantes Bit folgt.

Es ist weiterhin vorteilhaft für die Kennzeichnungs- und Synchronisierungszwecke, wenn die zweite Kennzeichnung (BRS) ebenfalls durch ein rezessives Bit im Control Field erfolgt, welches zeitlich nach dem Bit der ersten Kennzeichnung (EDL) übertragen wird, insbesondere wenn dieses vom rezessiven Bit der ersten Kennzeichnung durch wenigstens ein dominantes Bit getrennt ist.

Bei Vorliegen der ersten Kennzeichnung kann in vorteilhafter Weise die Flanke zwischen dem rezessiven Bit der ersten Kennzeichnung und dem wenigstens einen folgenden dominanten Bit zur Re-Synchronisierung oder Hard-Synchronisierung des Bit-Timings der Busteilnehmer genutzt werden, was die Zuverlässigkeit und Fehlersicherheit der Datenübertragung insbesondere bei nachfolgender Umschaltung der Bitlänge erhöht.

Es ist weiterhin von Vorteil, wenn in Abhängigkeit vom Wert der ersten Umschaltbedingung jede der möglichen Wertekombinationen der vier Bits des Data Length Code einer der zulässigen Größen des Datenfeldes zugeordnet ist. Dadurch wird eine transparente und flexible Möglichkeit zur Verwendung zahlreicher unterschiedlicher Größen des Datenfeldes geschaffen.

Die erste Kennzeichnung wird vorteilhafterweise in den Busteilnehmern ausgewertet und abhängig von der ersten Kennzeichnung wird der Empfangsprozess an die Größe des Control Field und/oder des Datenfeldes und/oder der nachfolgenden Bestandteile der Nachricht, insbesondere des CRC Feldes, angepasst. Auch die zweite Kennzeichnung wird in den Busteilnehmern bei Vorliegen der ersten Kennzeichnung ausgewertet und abhängig vom Wert der zweiten Kennzeichnung der Empfangsprozess an die unterschiedlichen Werte der Bitlänge innerhalb einer Nachricht angepasst wird. Dadurch bleibt die hohe Fehlererkennungswahrscheinlichkeit bei Übertragungsfehlern, die den CAN-Bus auszeichnet, erhalten, denn alle Busteilnehmer können abhängig von der Kennzeichnung die Einhaltung der Protokollvorgaben prüfen.

In vorteilhafter, weil den Implementierungsaufwand minimierender Weise werden die mindestens zwei unterschiedlichen Werte der zeitlichen Bitlänge innerhalb einer Nachricht durch Verwendung mindestens zweier unterschiedlicher Skalierungsfaktoren zur Einstellung der Bus-Zeiteinheit relativ zu einer kleinsten Zeiteinheit oder dem Oszillatortakt im laufenden Betrieb realisiert.

Bei Vorliegen einer weiteren Kennzeichnung, welche mit der ersten Kennzeichnung (EDL) übereinstimmen kann, weist in einer vorteilhaften Ausprägung das CRC Field der Nachrichten eine von der CAN Norm ISO 11898-1 abweichende Anzahl von Bits aufweist und / oder es wird wenigstens ein von der CAN-Norm ISO 11898-1 abweichendes Generator-Polynom verwendet, so dass auch bei größeren übertragenen Datenfeldern die gewünschte Fehlererkennungswahrscheinlichkeit erreicht wird. Auch der Wert dieser weiteren Kennzeichnung wird in den Busteilnehmern ermittelt und abhängig davon und / oder vom Inhalt des Data Length Code der Empfangsprozess an die Größe des CRC Field angepasst wird.

Besonders vorteilhaft ist es, wenn zu Beginn einer erfindungsgemäßen Nachricht die Berechnung von wenigstens zwei CRC Checksummen mittels unterschiedlicher Generator-Polynome parallel gestartet wird und erst, wenn aufgrund der Kennzeichnung feststeht, welches CRC-Prüfungsverfahren für die Übertragung der Nachricht anzuwenden ist, entschieden wird, welches Ergebnis aus einer der parallel gestarteten CRC-Berechnungen verwendet wird.

Das Verfahren ist vorteilhaft einsetzbar im normalen Betrieb eines Kraftfahrzeuges zur Übertragung von Daten zwischen wenigstens zwei Steuergeräten des Kraftfahrzeuges, welche über einen geeigneten Datenbus verbunden sind. Es ist aber gleichermaßen vorteilhaft einsetzbar während der Fertigung oder Wartung eines Kraftfahrzeuges zur Übertragung von Daten zwischen einer zum Zwecke der Programmierung mit einem geeigneten Datenbus verbundenen Programmierungseinheit und wenigstens einem Steuergerät des Kraftfahrzeuges, welches mit dem Datenbus verbunden ist.

Ein weiterer Vorteil ist, dass ein Norm-CAN Controller nur minimal geändert werden muss, um erfindungsgemäß arbeiten zu können. Ein erfindungsgemäßer Kommunikationscontroller, der auch als Norm-CAN Controller arbeiten kann, ist nur unwesentlich größer als ein herkömmlicher Norm-CAN Controller. Das zugehörige Anwendungs-Programm muss nicht geändert werden, und schon dann werden Vorteile in der Geschwindigkeit der Datenübertragung erzielt.

Es können in vorteilhafter Weise erhebliche Teile des CAN-Conformance-Tests (ISO 16845) übernommen werden. In einer vorteilhaften Ausprägung kann das erfindungsgemäße Übertragungsverfahren mit den Ergänzungen des TTCAN (ISO 11898-4) kombiniert werden.

### Zeichnungen

Die Erfindung wird im Weiteren anhand der Zeichnungen näher erläutert.
Figur la zeigt die zwei Alternativen für den Aufbau von Daten-Nachrichten gemäß der CAN-Norm ISO 11898-1, das CAN Standard Format und das CAN Extended Format.
Figur 1b zeigt zwei Beispiele für das Format von demgegenüber erfindungsgemäß modifizierten "CAN FD Long" Nachrichten mit geändertem Control Field und flexibler Größe von Datenfeld und CRC Field. Dargestellt sind sowohl eine Modifikation einer Standard CAN Nachricht, als auch eine Modifikation einer Extended CAN Nachricht.
Figur 2 stellt verschiedene Möglichkeiten dar, wie der Inhalt des Data Length Code erfindungsgemäß abweichend von der CAN-Norm ISO 11898-1 interpretiert werden kann.
Figur 3 stellt schematisch ein Ausführungsbeispiel für den Empfangsprozess auf einer Teilnehmerstation vom Typ "CAN FD Long" des Bussystems dar.
Figur 4 zeigt zwei weitere Beispiele für erfindungsgemäß modifizierte Nachrichten vom Typ "CAN FD Fast", bei welchen gegenüber Figur 1b zusätzlich Bereiche innerhalb der Nachricht festgelegt sind, in welchen erfindungsgemäß eine unterschiedliche Bitlänge verwendet wird.
Figur 5 stellt schematisch ein Ausführungsbeispiel für den erfindungsgemäßen Empfangsprozess auf einer Teilnehmerstation vom Typ "CAN FD Fast" des Bussystems dar.

### Beschreibung der Ausführungsbeispiele

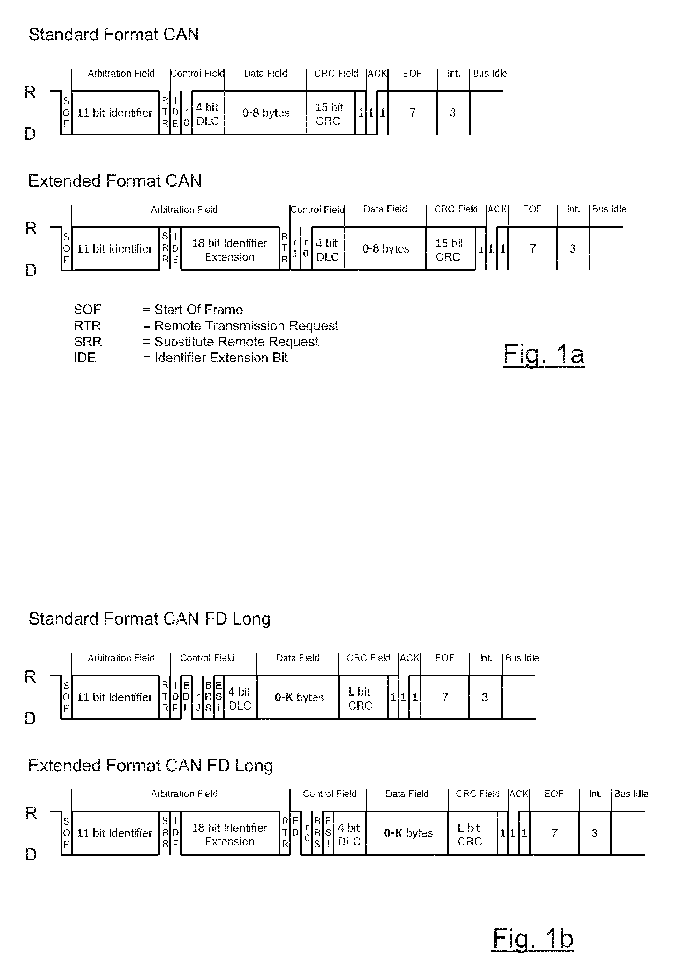

In Figur 1a ist der Aufbau von Nachrichten, wie sie auf einem CAN Bus zur Datenübertragung verwendet werden, dargestellt. Die beiden unterschiedlichen Formate "Standard" und "Extended" sind dargestellt. Das erfindungsgemäße Verfahren ist in geeigneten Ausführungsformen auf beide Formate anwendbar.

Die Nachricht beginnt mit einem "Start of Frame"(SOF)-Bit, das den Beginn der Nachricht signalisiert. Es schließt sich ein Abschnitt an, der in erster Linie zur Identifizierung der Nachricht dient, und anhand dessen die Teilnehmer des Bussystems entscheiden, ob sie die Nachricht empfangen oder nicht. Dieser Abschnitt wird mit "Arbitration Field" bezeichnet und enthält den Identifier. Es folgt ein "Control Field", das unter anderem den Data Length Code enthält. Der Data Length Code enthält Informationen über die Größe des Datenfeldes der Nachricht. Hieran schließt sich das eigentliche Datenfeld "Data Field" an, das die zwischen den Teilnehmern des Bussystems auszutauschenden Daten enthält. Es folgt das "CRC Field" mit der 15 Bit umfassenden Checksumme und einem Delimiter, und anschließend zwei "Acknowledge"(ACK)-Bits, die dazu dienen, den erfolgreichen Empfang einer Nachricht an den Sender zu signalisieren. Abgeschlossen wird die Nachricht durch eine "End of Frame"(EOF)-Sequenz.

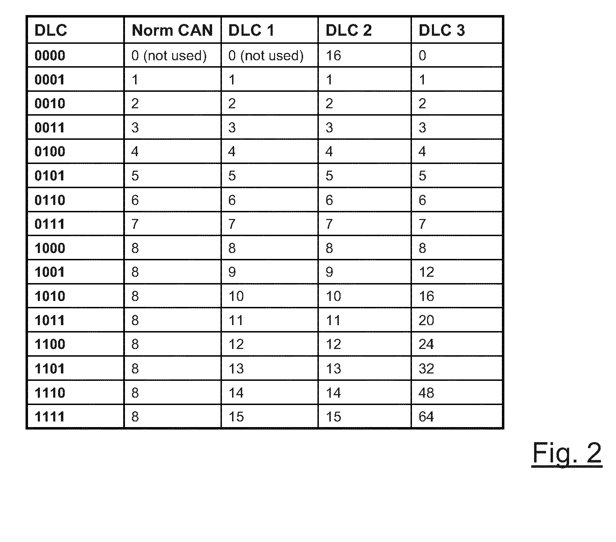

Bei dem CAN Übertragungsverfahren nach der Norm darf das Datenfeld maximal 8 Byte, also 64 Bit an Daten enthalten. Der Data Length Code umfasst gemäß der Norm vier Bits, kann also 16 verschiedene Werte annehmen. Benutzt werden aus diesem Wertebereich in heutigen Bussystemen lediglich acht verschiedene Werte für die unterschiedlichen Größen des Datenfeldes von 1 Byte bis zu 8 Byte. Ein Datenfeld von 0 Byte ist im Norm CAN nicht empfohlen, Größen oberhalb von 8 Byte sind nicht zulässig. Die Zuordnung der Werte des Data Length Code zu den Größen des Datenfeldes ist in Figur 2 in der Spalte CAN Norm dargestellt.

In Figur 1b sind in analoger Darstellung die erfindungsgemäß zu übertragenden, modifizierten Nachrichten, jeweils abgeleitet von den beiden Norm-Formaten, gegenübergestellt. Sie unterscheiden sich von den normgemäßen Nachrichten aus Figur 1a durch die Ergänzung einiger zusätzlicher Bits im Control Field, die mit EDL, BRS, ESI bezeichnet sind und deren Zweck im Folgenden noch erläutert wird. Weiterhin unterscheiden sich die erfindungsgemäßen Nachrichten durch die variable Größe von Data Field und CRC Field. Die Nachrichten tragen daher die Bezeichnung "CAN FD Long".

Bei dem erfindungsgemäß modifizierten Übertragungsverfahren darf das Datenfeld auch mehr als 8 Byte enthalten, nämlich in der dargestellten Ausprägung bis zu K Byte. Anders als im Norm CAN werden weitere Werte, die der Data Length Code einnehmen kann, ausgenutzt, um größere Datenfelder zu kennzeichnen. Beispielsweise können die vier Bits des Data Length Code benutzt werden, um die Werte von null bis 15 Byte darzustellen. Es können aber auch andere Zuordnungen getroffen werden, beispielsweise ist es eine Möglichkeit, den in heutigen CAN-Nachrichten üblicherweise nicht genutzten Wert des Data Length Code DLC = 0b0000 für eine weitere mögliche Größe des Datenfeldes zu benutzen, beispielsweise für die Größe 16 Byte.

Diese beiden Möglichkeiten sind in Figur 2 in Tabellenform als DLC 1 und DLC 2 dargestellt. Die Maximalgröße des Datenfeldes K hat in diesen Fällen den Wert 15 bzw. 16. Eine weitere Möglichkeit ist es, dass für die Werte des Data Length Code größer 0b1000 und bis 0b1111 die zugehörigen Größen des Datenfeldes um ein größeres Inkrement anwachsen. Ein Beispiel für diesen Fall ist in der Tabelle als DLC 3 dargestellt. Die Maximalgröße des Datenfeldes K erreicht in dieser Variante den Wert 64 Byte. Eine andere Wahl ist selbstverständlich möglich, beispielsweise ein Inkrement von jeweils 4 Byte.

Um zu gewährleisten, dass ein erfindungsgemäßer Kommunikationscontroller feststellen kann, in welcher Art er die Inhalte des Data Length Code zu interpretieren hat, ist es vorteilhaft, dass er selbständig erkennt, ob die Kommunikation des Bussystems nach Norm CAN oder dem erfindungsgemäßen Verfahren abläuft. Eine Möglichkeit hierzu besteht darin, ein Bit innerhalb des Arbitration Field oder des Control Field, welches im Norm-CAN immer mit einem festen Wert übertragen wird, zur Kennzeichnung heranzuziehen, so dass aus dieser ersten Kennzeichnung der Kommunikationscontroller eine erste Umschaltbedingung ableiten kann, abhängig von der er das anzuwendende Übertragungsverfahren auswählt.

### Kennzeichnung bei Standard Adressierung:

Das zweite Bit des Control Field von Norm-CAN Daten-Nachrichten wird im Standard Format, wie in Figur 1a im oberen Teil dargestellt, stets dominant gesendet und mit r0 bezeichnet. In dem in Figur 1b im oberen Teil dargestellten Beispiel einer erfindungsgemäßen Nachricht mit Standard Adressierung (d.h. mit einem Arbitration Field gemäß Standard CAN Format) wird dieses zweite Bit des Control Field zur Kennzeichnung verwendet, indem es rezessiv gesendet wird. Ein rezessiver Wert des zweiten Bits des Control Fields in einer solchen Nachricht zeigt also an, dass im Folgenden das von der Norm abweichende Nachrichtenformat übertragen wird. Dieses rezessiv übertragene zweite Bit des Control Field einer Nachricht mit Standard Arbitration Field wird mit EDL (Extended Data Length) bezeichnet. Das im Norm-CAN stets dominant übertragene Bit r0 wird in den erfindungsgemäßen Nachrichten durch das rezessive EDL-Bit ersetzt, oder es rückt in den erfindungsgemäßen Nachrichten eine Position nach hinten auf den Platz zwischen dem rezessiven Bit EDL und dem bei Umschaltung der Bitlänge ebenfalls rezessiven Bit BRS. Weiterhin können im Control Field noch weitere Bits eingefügt werden. Dargestellt ist in Figur 1b zum Beispiel ein ESI genanntes Bit, auf das später noch eingegangen wird. Es könnten an dieser Stelle auch zwei oder mehr Bits eingefügt werden, ohne das erfindungsgemäße Verfahren zu beeinflussen.

Insgesamt wird also die Bitfolge im Control Field von Standard Norm-CAN Nachrichten
{IDE, r0, DLC3, DLC2, DLC1, DLC0}
in erfindungsgemäßen Nachrichten ersetzt durch
{IDE, EDL, N weitere Bits, DLC3, DLC2, DLC1, DLC0}.

In dem in Figur 1b dargestellten Beispiel gilt N=3 mit den eingefügten Bits r0, BRS, ESI. N könnte aber auch beliebige andere Werte größer Null annehmen. Das Bit BRS sollte gegebenenfalls - aus Gründen, die später erläutert werden - nach einem stets dominant übertragenen Bit, beispielsweise in Kombination mit und direkt nach dem Bit r0, eingefügt werden.

### Kennzeichnung bei Extended Adressierung:

Die ersten beiden Bits des Control Field von Norm-CAN Daten-Nachrichten werden im Extended Format, wie in Figur 1a im unteren Teil dargestellt, stets dominant gesendet und mit r1 und r0 bezeichnet. In dem in Figur 1b im unteren Teil dargestellten Beispiel einer erfindungsgemäßen Nachricht mit Extended Adressierung (d.h. mit einem Arbitration Field gemäß Extended CAN Format) wird das erste Bit r1 des Control Field zur Kennzeichnung verwendet, indem es rezessiv gesendet wird. Ein rezessiver Wert des ersten Bits des Control Fields in einer solchen Nachricht zeigt in diesem Fall an, dass im Folgenden das von der Norm abweichende Nachrichtenformat übertragen wird. Auch hier wird dieses rezessiv übertragene Bit des Control Field mit EDL (Extended Data Length) bezeichnet. Es ersetzt das reservierte, dominante Bit r1 der Norm-CAN Nachrichten mit Extended Format. Alternativ könnte das dominante Bit r1 auch erhalten bleiben und einen Platz nach hinten rücken, so dass das EDL-Bit als zusätzliches Bit zwischen RTR und r1 eingefügt wäre. Ebenfalls möglich wäre es, das EDL-Bit (rezessiv) als zusätzliches Bit zwischen r1 (dominant) und r0 (dominant) einzufügen. Anschließend können auch in diesem Fall im Control Field noch weitere Bits eingefügt werden. Dargestellt ist in Figur 1b zum Beispiel wieder das ESI genannte Bit, auf das noch eingegangen wird. Es könnten auch zwei oder mehr Bits eingefügt werden, ohne das erfindungsgemäße Verfahren zu beeinflussen. Insgesamt wird also die Bitfolge im Control Field von Extended Norm-CAN Nachrichten
{r1, r0, DLC3, DLC2, DLC1, DLC0}
in erfindungsgemäßen Nachrichten ersetzt durch
{EDL, N weitere Bits, DLC3, DLC2, DLC1, DLC0} oder
{r1, EDL, M weitere Bits, DLC3, DLC2, DLC1, DLC0}.

Das in Figur 1b dargestellte Beispiel zeigt die erstgenannte Variante mit N=3, nämlich mit den eingefügten Bits r0, BRS, ESI. N beziehungsweise M könnten aber auch auch beliebige andere Werte größer Null annehmen. Das Bit BRS sollte auch hier gegebenenfalls - aus Gründen, die später erläutert werden - nach einem stets dominant übertragenen Bit, beispielsweise in Kombination mit und direkt nach dem Bit r0, eingefügt werden.

Es ist alternativ auch möglich, das Verfahren in geeigneten Kommunikationscontrollern zur Anwendung zu bringen, die nicht auch zur normgemäßen CAN Kommunikation ausgelegt sind. In diesem Fall kann auch die Festlegung der genannten ersten Umschaltbedingung, beispielsweise abhängig von einer geeigneten Kennzeichnung der Nachrichten, entfallen. Die Kommunikationscontroller arbeiten in diesem Fall vielmehr ausschließlich gemäß einem der beschriebenen Verfahren und sind dementsprechend nur in Bussystemen einsetzbar, in welchen ausschließlich solche erfindungsgemäßen Kommunikationscontroller im Einsatz sind.

Wird, wie in der Erfindung vorgesehen, das Datenfeld von Nachrichten vergrößert, so kann es sinnvoll sein, auch das verwendete Verfahren zum Cyclic Redundancy Check (CRC) anzupassen, um eine ausreichende Fehlersicherheit zu erhalten. Insbesondere kann es vorteilhaft sein, ein anderes CRC-Polynom, beispielsweise mit höherer Ordnung, zu verwenden und entsprechend eine CRC Field abweichender Größe in den erfindungsgemäß modifizierten Nachrichten vorzusehen. Dies ist in Figur 1b dadurch dargestellt, dass das CRC Field der erfindungsgemäßen Nachrichten im dargestellten Beispiel eine Länge von L Bit aufweist, wobei L abweichend vom Norm CAN ungleich, insbesondere größer als 15 sein kann.

Die Verwendung eines modifizierten Verfahrens zur Berechnung der CRC Checksumme kann durch eine weitere Kennzeichnung, welche eine weitere Umschaltbedingung darstellt, den Busteilnehmern signalisiert werden. Diese weitere Kennzeichnung kann in einer bevorzugten Ausführungsform mit der ersten Kennzeichnung und / oder Umschaltbedingung übereinstimmen.

In den Norm CAN-Controllern wird der CRC-Code von zu sendenden CAN-Nachrichten mittels eines rückgekoppelten Schieberegisters erzeugt, in dessen Eingang die seriell gesendeten Bits der Nachricht sequenziell eingespeist werden. Die Breite des Schieberegisters entspricht der Ordnung des CRC-Polynoms. Die CRC-Codierung erfolgt durch eine Verknüpfung des Register-Inhalts mit dem CRC-Polynom während der Shift-Operationen. Wenn CAN-Nachrichten empfangen werden, werden entsprechend die seriell empfangenen Bits der Nachricht in das CRC-Schieberegister geschoben. Der CRC-Test ist erfolgreich, wenn am Ende des CRC-Feldes alle Bits des Schieberegisters auf Null stehen. Die CRC-Code-Generierung im Sendefall und der CRC-Test im Empfangsfall erfolgen beide in Hardware, ohne dass ein Eingriff der Software notwendig ist. Eine Modifikation der CRC-Codierung hat also keine Auswirkung auf die Anwendungs-Software.

In einer besonders vorteilhaften Ausführungsform wird der Kommunikationscontroller so ausgelegt, dass er Kompatibilität zum Norm CAN aufweist, also in einem Norm CAN Bussystem normgemäß arbeitet, während er in einem erfindungsgemäß modifizierten Bussystem einerseits größere Datenfelder in den Nachrichten zulässt und andererseits auch die angepasste Berechnung und Prüfung des CRC-Code durchführt.

Da am Anfang des Empfanges einer Nachricht noch nicht feststeht, ob eine Norm-konforme CAN-Nachricht oder eine erfindungsgemäß modifizierte Nachricht empfangen wird, werden in einem erfindungsgemäßen Kommunikationscontroller zwei CRC-Schieberegister implementiert, die parallel arbeiten. Nach dem Empfang des CRC Delimiter, wenn der CRC-Code im Empfänger ausgewertet wird, steht aufgrund der erfindungsgemäßen weiteren Kennzeichnung fest, welches Übertragungsverfahren angewendet wurde, und es wird dann das diesem Übertragungsverfahren zugeordnete Schieberegister ausgewertet. Die weitere Kennzeichnung kann, wie früher bereits dargestellt, mit der ersten Kennzeichnung, die die Größe des Datenfeldes und die Interpretation des Data Length Code betrifft, übereinstimmen.

Am Anfang des Sendens einer Nachricht steht zwar für den Sender bereits fest, nach welchem Übertragungsverfahren gesendet werden soll. Da es jedoch vorkommen kann, dass die Arbitration um den Buszugriff verloren wird und die begonnene Nachricht nicht gesendet, sondern stattdessen eine andere Nachricht empfangen wird, werden auch hier beide CRC-Schieberegister parallel angesteuert.

Die beschriebene Implementation zweier parallel arbeitender CRC-Schieberegister ermöglicht auch eine weitere Verbesserung:
Das CRC-Polynom des Norm CAN-Protokolls (x15 + x14 + x10 + x8 + x7 + x4 + x3 + 1) ist für eine Nachrichten-Länge von weniger als 127 Bits ausgelegt. Wenn erfindungsgemäß übertragene Nachrichten auch längere Datenfelder verwenden, ist es sinnvoll, zur Aufrechterhaltung der Übertragungssicherheit ein anderes, insbesondere längeres CRC-Polynom zu verwenden. Die erfindungsgemäß übermittelten Nachrichten erhalten dementsprechend ein geändertes, insbesondere längeres CRC Field. Im laufenden Betrieb wechseln die Kommunikationscontroller dynamisch zwischen den beiden CRC-Schieberegistern, also dem Norm CAN-gemäßen und dem erfindungsgemäßen Schieberegister, um das jeweils passende Polynom zu verwenden.

Natürlich können auch mehr als zwei Schieberegister und dementsprechend mehr als zwei CRC-Polynome abgestuft in Abhängigkeit von der Länge des Datenfeldes oder der gewünschten Übertragungssicherheit zum Einsatz kommen. In diesem Fall muss, sofern eine Kompatibilität zum Norm CAN erhalten bleiben soll, die entsprechende Kennzeichnung und die damit verbundene Umschaltbedingung angepasst werden. Beispielsweise könnte das zweite Bit des Control Field eine erste Kennzeichnung darstellen, welche ein Umschalten auf längere Datenfelder, beispielsweise gemäß DLC 1 auf Figur 2, und ein zugehöriges zweites CRC-Polynom kennzeichnet. Für Nachrichten, die längere Datenfelder enthalten und durch die erste Kennzeichnung gekennzeichnet sind, könnte beispielsweise ein zusätzliches Bit im Control Field eingefügt werden, welches die Umschaltung auf einen weiteren Satz von Datenfeldgrößen, beispielsweise DLC 3 aus Figur 2, und ein drittes CRC-Polynom kennzeichnet. Das Einfügen von zusätzlichen Bits in das Control Field von Nachrichten, die die erste Kennzeichnung aufweisen, ist möglich, da hier ohnehin ein geänderter Sende- und Empfangsprozess im Kommunikationscontroller zur Anwendung kommt, und somit derartige Änderungen berücksichtigt werden können. Die Kompatibilität mit Norm-CAN ist dadurch gegeben, dass bei Nicht-Vorliegen der ersten Kennzeichnung, im gezeigten Beispiel also bei dominantem zweitem Bit des Control Field, der Aufbau der Nachrichten exakt den Vorgaben der ISO-Norm 11898-1 folgt.

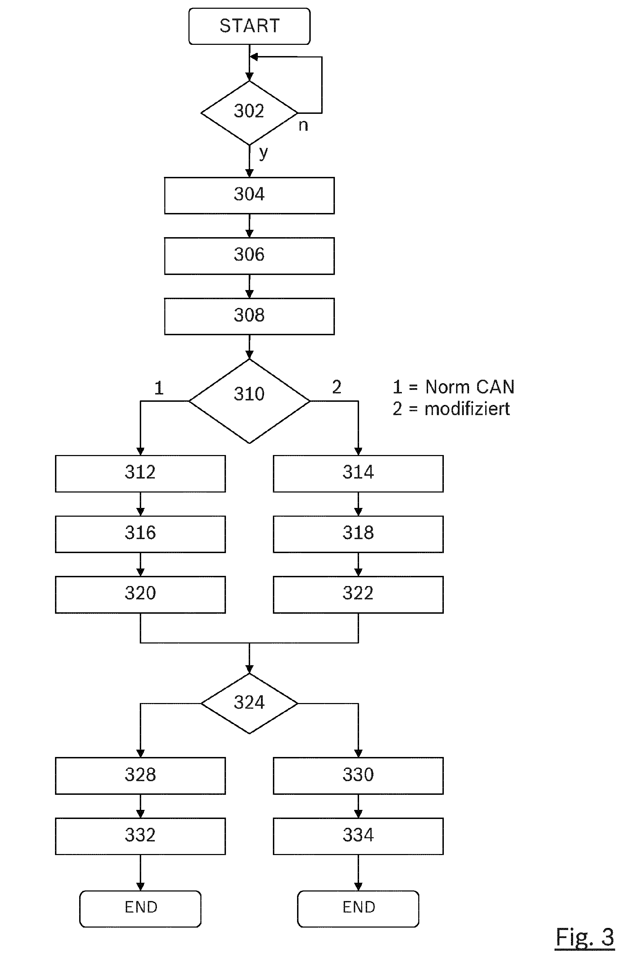

Figur 3 zeigt in vereinfachter Darstellung einen Ausschnitt des erfindungsgemäßen Empfangsprozesses, wie er auf einer Teilnehmerstation des Bussystems abläuft. Dargestellt ist hier der Fall, bei welchem eine Kompatibilität zum Norm CAN erreicht wird, indem abhängig von der ersten Umschaltbedingung das Verhalten des Kommunikationscontrollers angepasst wird. Obwohl in Figur 3 eine für die Beschreibung von Programmabläufen in Software übliche Darstellung gewählt wurde, ist das Verfahren vollständig zur Implementierung in Hardware geeignet.

Die Teilnehmerstation befindet sich zunächst in einem den Bus abtastenden Zustand, so lange auf dem Bus kein Kommunikationsverkehr herrscht. Die Abfrage 302 wartet also auf ein dominantes Bit auf dem Bus. Dieses Bit kennzeichnet den Beginn einer neuen Nachricht (Start-of-Frame).

Sobald der Beginn einer neuen Nachricht festgestellt wurde beginnt im Block 304 die Berechnung der wenigstens zwei parallel zu berechnenden Checksummen. Die erste Checksumme entspricht der CRC Berechnung des Norm CAN, während die zweite Checksumme nach dem neuen Verfahren berechnet wird.

Es werden anschließend ab dem Schritt 306 die weiteren, auf das SOF-Bit folgenden Bits der Nachricht, beginnend mit dem Arbitration Field, empfangen. Falls mehrere Busteilnehmer eine Nachricht versenden wollen, wird hierbei nach dem aus dem Norm CAN üblichen Verfahren unter den Busteilnehmern ausgehandelt, welcher Busteilnehmer den Zugriff auf den Bus erhält. Der dargestellte Block 306 kennzeichnet den Empfang aller Bits, bis die erste Kennzeichnung empfangen wurde beziehungsweise die erste Umschaltbedingung feststeht. Im dargestellten Beispiel wird die erste Umschaltbedingung aus dem Control Field, beispielsweise aus dem zweiten Bit desselben, ermittelt (vgl. Figur 1). Anschließend können in Block 308 noch weitere Bits der Nachricht empfangen werden, bis ab einem bestimmten Bit der Nachricht abhängig von der ermittelten ersten Umschaltbedingung unterschiedlich verfahren wird. Diese Aufspaltung in unterschiedliche Verfahrensweisen wird durch eine entsprechende Abfrage oder Verzweigung 310 gewährleistet, wie im Folgenden beispielhaft dargestellt.

Liegt bei der Verzweigung 310, beispielsweise nach Empfang des zweiten Bits des Control Field als dominantem Bit r0, die Information vor, dass gemäß der ersten Kennzeichnung die Kommunikation nach Norm CAN erfolgt (der mit "1" bezeichnete Pfad der Figur 3), so werden im Schritt 312 die weiteren Bits des Control Field eingelesen. Aus diesen Bits wird gemäß Norm CAN der Data Length Code ausgewertet und es wird anschließend in Schritt 316 die zugehörige Menge an Daten, maximal 8 Byte, entsprechend dem Datenfeld, empfangen. Im Schritt 320 wird dann das 15 Bit umfassende CRC Feld empfangen. Liegt bei der Verzweigung 324 die Information vor, dass die die vom Sender übermittelte und die vom Empfänger selbst ermittelte CRC Checksumme übereinstimmen, wird in Block 328 ein dominantes Acknowledge-Bit gesendet. Es ist zu beachten, dass in diesem Fall die normgemäße CRC Checksumme verglichen wird, da die Kommunikation nach Norm CAN erfolgt. Wird keine Übereinstimmung festgestellt, wird (Block 330) das Acknowledge-Bit rezessiv gesendet. Anschließend folgen in Schritt 332 beziehungsweise 334 der ACK Delimiter und die EOF Bits. Damit ist ein Empfangsprozess für eine Nachricht beendet.

Liegt hingegen bei der Verzweigung 310, beispielsweise nach Empfang des zweiten Bits des Control Field als rezessivem Bit EDL, die Information vor, dass das erfindungsgemäß modifizierte Kommunikationsverfahren anzuwenden ist (der mit "2" bezeichnete Pfad der Figur 3), so werden im Block 314 die weiteren Bits des Control Field eingelesen. Hier können beispielsweise auch zusätzliche, im Control Field ergänzte Bits eingelesen werden, die beispielsweise zur Umschaltung auf ein weiteres abweichendes CRC-Polynom dienen können, oder auch zur Umschaltung der Bitlänge, zur Synchronisierung oder zu weiteren Zwecken. Auf dieses Aspekt wird noch detaillierter eingegangen. Aus dem Ergebnis wird der Data Length Code nach der neuen Interpretation, für die einige Beispiele tabellenartig in Figur 2 aufgeführt sind, ermittelt. Im Block 318 wird die entsprechende Menge an Daten, also für das Beispiel DLC 1 aus der Tabelle in Figur 2 bis zu 15 Byte, für das Beispiel DLC 2 bis zu 16 Byte, für das Beispiel DLC 3 bis zu 64 Byte Daten empfangen. Im Block 322 wird das erfindungsgemäß abweichende, insbesondere längere CRC Feld empfangen. Liegt bei der Verzweigung 324 die Information vor, dass die vom Sender übermittelte und die vom Empfänger selbst ermittelte CRC Checksumme übereinstimmen, wobei in diesem Fall der Vergleich auf der erfindungsgemäß abweichenden CRC Checksumme basiert, wird in Block 328 ein dominantes Acknowledge-Bit gesendet. Andernfalls wird (Block 330) das Acknowledge-Bit rezessiv gesendet. Anschließend folgen in Schritt 332 beziehungsweise 334 der ACK Delimiter und die EOF Bits. Damit ist ein Empfangsprozess für eine Nachricht beendet.

In Figur 3 wurde der Fall dargestellt, in welchem die weitere Kennzeichnung, welche die zu verwendende CRC bestimmt, mit der ersten Kennzeichnung, die die Größe des Datenfeldes und die Interpretation des Data Length Code betrifft, übereinstimmt. Es wurde also vor dem Empfang 320 beziehungsweise 322 der CRC Checksummen nicht nochmals abgefragt, welche CRC gemäß der weiteren Kennzeichnung zu empfangen und für die Verzweigung 324 auszuwerten ist. Durch eine einfache Modifikation des Ablaufdiagrammes aus Figur 3 ist diese zusätzliche Abfrage gegebenenfalls in den Ablauf aufnehmbar.

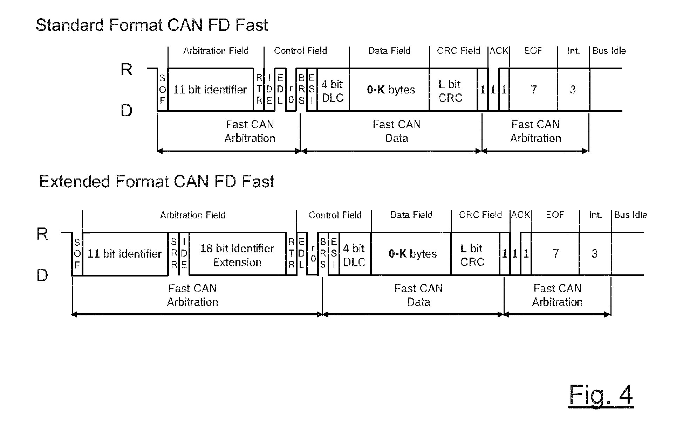

Figur 4 zeigt zwei weitere Beispiele für erfindungsgemäß modifizierte Nachrichten, bei welchen gegenüber Figur 1b zusätzlich Bereiche innerhalb der Nachricht festgelegt sind, in welchen erfindungsgemäß eine unterschiedliche Bitlänge verwendet wird und somit die einzelnen Bits schneller über den Bus übertragen werden. Die Nachrichten tragen daher die Bezeichnung "CAN FD Fast". Für die zwei möglichen Adressierungsvarianten von Nachrichten, das Standard Format und das Extended Format, sind in Figur 4 Bereiche eingezeichnet, in denen zwischen zwei Zuständen, bezeichnet mit Fast-CAN-Arbitration und Fast-CAN-Data umgeschaltet wird. Diese Umschaltung zwischen den beiden Zuständen bewirkt, dass für den entsprechenden Teil der Nachricht die Bitlängen verkürzt und somit die einzelnen Bits schneller über den Bus übertragen werden. Dadurch kann die Übertragungszeit für eine Nachricht gegenüber dem normgemäßen Verfahren verkürzt werden. Der zugehörige Wechsel der zeitlichen Bitlänge kann beispielsweise durch Verwendung mindestens zweier unterschiedlicher Skalierungsfaktoren zur Einstellung der Bus-Zeiteinheit relativ zu einer kleinsten Zeiteinheit oder dem Oszillatortakt im laufenden Betrieb realisiert werden. Die Umschaltung der Bitlänge, sowie die entsprechende Veränderung des Skalierungsfaktors sind in Figur 4 ebenfalls beispielhaft dargestellt.

Der Übergang zwischen den Zuständen Fast-CAN-Arbitration und Fast-CAN-Data erfolgt in Nachrichten, welche die erste Kennzeichnung EDL aufweisen, abhängig von einer zweiten Kennzeichnung, die den Teilnehmern der Datenübertragung signalisiert, dass die verkürzte Bitlänge angewendet wird. In dem hier dargestellten Ausführungsbeispiel ist die Position dieser Kennzeichnung ein zusätzliches Bit im Control Field, das mit BRS (Bit Rate Switch) bezeichnet ist. Es wird im gezeigten Beispiel als viertes Bit des Control Field übertragen.

In dem dargestellten Fall, in dem also auf die erste Kennzeichnung EDL die zweite Kennzeichnung BRS folgt, werden im erfindungsgemäßen Übertragungsverfahren Nachrichten übertragen, deren Bitlänge deutlich verkürzt, deren Datenfeldgröße auf Werte oberhalb 8 Byte ausdehnbar, und deren CRC an das größere Datenfeld angepasst ist. Erhebliche Steigerung der Übertragungskapazität über das Bussystem bei gleichzeitig verbesserter Übertragungssicherheit werden so erreicht.

Die schnellere Übertragung beginnt im dargestellten Beispiel unmittelbar nach Versenden der zugehörigen Kennzeichnung und wird unmittelbar nach Erreichen des für die Rückumschaltung festgelegten Bits beendet oder dann, wenn ein Grund zum Start eines Error-Frames erkannt wurde.

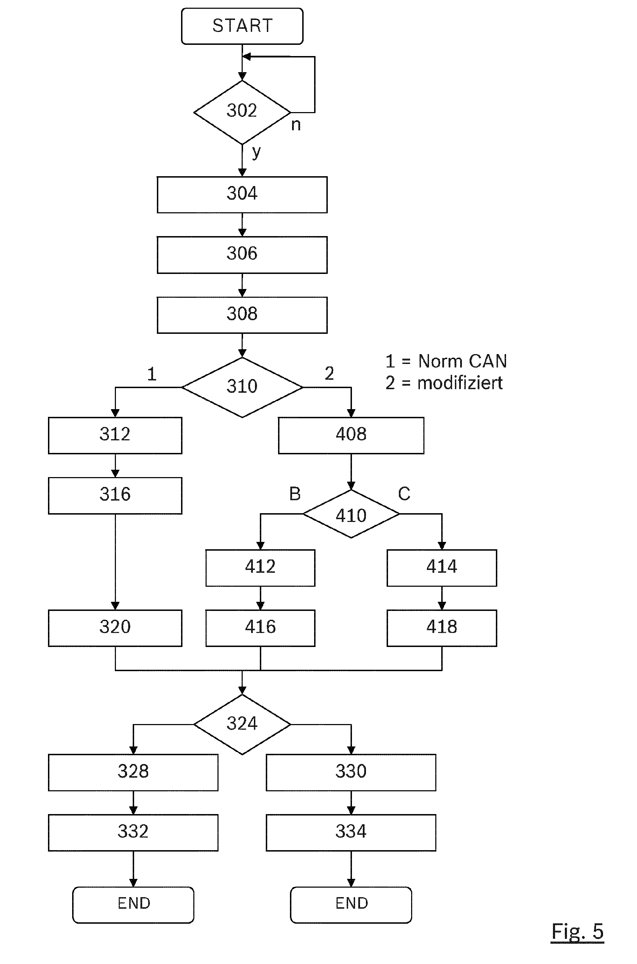

Figur 5 zeigt einen gegenüber Figur 3 modifizierten Empfangsprozess, bei welchem zusätzlich abhängig von der zweiten Kennzeichnung BRS zwischen den Zuständen Fast-CAN-Arbitration und Fast-CAN-Data umgeschaltet wird. Liegt bei der Verzweigung 310, beispielsweise nach Empfang des zweiten Bits des Control Field als rezessivem Bit EDL, die Information vor, dass das erfindungsgemäß modifizierte Kommunikationsverfahren anzuwenden ist, so werden im Block 408 die nächsten Bits des Control Field eingelesen. Wird das zur zweiten Kennzeichnung dienende Bit, beispielsweise das vierte Bit BRS des erfindungsgemäß erweiterten Control Field, mit dem vorgesehenen Wert, beispielsweise rezessiv, empfangen, so wird beispielsweise am Sample Point dieses Bits der Zustand Fast-CAN-Data eingenommen, also auf die verkürzte Bitlänge umgeschalten (Pfad "C"). Weist das betreffende Bit den umgekehrten Wert auf, also in diesem Beispiel dominant, so erfolgt keine Verkürzung der Bitlänge (Pfad "B"). In den Blöcken 412 beziehungsweise 414 erfolgt der Empfang der verbleibenden Bits des Control Field inklusive des Data Length Code und der Empfang des Datenfeldes gemäß der Größeninformation aus dem Data Length Code. Im Block 412 wird mit normaler Bitlänge empfangen, im Block 414 mit der verkürzten Bitlänge. In den Blöcken 416 beziehungsweise 418 wird das erfindungsgemäß abweichende, insbesondere längere CRC Field eingelesen. Am letzten Bit des CRC Field, dem CRC Delimiter wird im Block 418 wieder in den Zustand Fast-CAN-Arbitration mit gewöhnlicher Bitrate umgeschalten. Anschließend wird bei der Verzweigung 324 analog zu Figur 3 geprüft, ob die vom Sender übermittelte und die vom Empfänger selbst ermittelte CRC Checksumme übereinstimmen und es wird abhängig davon weiter verfahren, wie schon in Figur 3.

Das auf das rezessive Bit der ersten Kennzeichnung EDL in den erfindungsgemäßen Nachrichten folgende, stets dominante Bit r0 (beziehungsweise bei Extended Adressierung eventuell rl) führt, wie beispielsweise in den Figuren 1b und 4 abzulesen ist, zu einer rezessivdominant-Flanke in allen erfindungsgemäßen Daten-Nachrichten. Diese Flanke kann zur Verbesserung der Synchronisierung zwischen den Busteilnehmern herangezogen werden, was insbesondere bei der vorgesehenen Umschaltung auf die kürzeren Bitlängen von Vorteil ist.

Wenn alle Busteilnehmer im Netzwerk auf den sendenden Teilnehmer synchronisiert sind, kann problemlos auf die kürzere Bitlänge umgeschaltet werden. Es kann aber auch vorkommen, dass an dem für die Umschaltung vorgesehenen Bit nicht alle Busteilnehmer auf den sendenden Teilnehmer synchronisiert sind, beispielsweise, wenn ein erster sendender Teilnehmer am Ende des Arbitration-Fields die Bitfolge "dominant-dominant" sendet und ein zweiter sendender Teilnehmer, der noch im Rahmen der Arbitrierung den Zugriff auf den Bus erlangen möchte, die Bitfolge "dominant-rezessiv" sendet. Der zweite sendende Teilnehmer verliert die Arbitration an dem rezessiven Bit und wird zum Empfänger. Bis zu dem rezessiven Bit hatten die beiden Sender dieselbe Bitfolge gesendet. Da beide Transmitter aufgrund der Laufzeiten über den CAN-Bus und die Transceiver die jeweils selbst gesendeten Flanken von rezessiv nach dominant früher sehen, als die vom jeweils anderen Sender gesendeten, hat sich keiner auf den anderen synchronisiert.

Wenn nun die Bitlänge umgeschaltet wird, bevor der neu zum Empfänger gewordene Busteilnehmer sich auf den verbleibenden Sender synchronisiert hat, erfolgt die Synchronisierung nach der Umschaltung, im Bereich der kürzeren Bitlänge. Die Phasenverschiebung durch die Synchronisation ist dann relativ zur Bitlänge größer. Je nach Signal-Laufzeit zwischen den beiden Busteilnehmern kann die Phasenverschiebung so groß werden, dass es zur Fehl-Synchronisation kommt und ein Bit falsch abgetastet wird. Der Empfänger wird dann die empfangene Nachricht nicht als gültig anerkennen und mit einem Error-Frame zerstören.

In der Norm-CAN-Kommunikation tritt dieses Problem nicht auf, da dort das Propagation-Segment des CAN Bit-Timings die durch Signal-Laufzeiten bewirkten Phasenverschiebungen zwischen den Busteilnehmern ausgleicht. In der Konfiguration für eine kürzere Bitlänge kann das Propagation-Segment jedoch minimiert oder ganz weggelassen werden, um die Bitlänge zu verkürzen.

Um die Fehl-Synchronisation nach der Umschaltung der Bitlänge zu vermeiden, muss eine Synchronisierung vor der Umschaltung der Bitlänge durch geeignete Maßnahmen garantiert werden. Dies kann dadurch erreicht werden, dass an der Flanke von EDL (rezessiv) zu r0 beziehungsweise r1 (dominant) eine Synchronisierung durchgeführt wird. Insbesondere kann eine Hard-Synchronisierung anstelle der sonst innerhalb eines Frames üblichen Re-Synchronisierung durchgeführt werden. Diese wird beispielsweise auch am Start-of-Frame-Bit durchgeführt und gleicht mögliche Phasenverschiebungen sicher vollständig aus. Bei der sonst innerhalb eines Frames üblichen Re-Synchronisierung kann ein Rest-Fehler verbleiben, wenn der Phasen-Fehler größer als die konfigurierte Re-Synchronisations-Sprungweite (SJW) ist.

Als eine Variante des dargestellten Verfahrens kann die Umschaltung auf verkürzte Bitlängen abhängig vom Wert der zweiten Kennzeichnung BRS zusätzlich mit dem dominanten Wert des vorher übertragenen r0-Bit gekoppelt werden, so dass nur auf die kürzere Bitlänge umgeschaltet wird, wenn r0 dominant übertragen wurde. Diese Ergänzung des Verfahrens erlaubt es, eine Bitfolge, bei welcher auf das rezessive EDL-Bit ein rezessives Bit an Stelle des dominanten r0-Bits folgt, für zukünftige, weitere Nachrichtenformate zu verwenden, wie zum Beispiel für eine von der Norm abweichende Bit-Codierung in Teilbereichen der Nachricht.

Die Möglichkeit, zusätzliche Bits im Control Field der erfindungsgemäßen Nachrichten einzufügen, kann weiterhin genutzt werden, um die Erkennung von Busteilnehmern, welche sich im "Error Passive" Zustand befinden, zu erleichtern. Ein Busteilnehmer mit Kommunikationscontroller aus dem Stand der Technik nimmt den Zustand "Error Passive" ein, wenn der Transmit oder Receive Error Count 128 oder höher ist. Befindet sich der Busteilnehmer im Zustand "Error Passive", so darf er keine "Active Error Flags" (sechs aufeinanderfolgende dominante Bits) senden. Detektiert der Busteilnehmer einen Fehler, sendet er ein "Passive Error Flag" (sechs aufeinanderfolgende rezessive Bits). Ein "Passive Error Flag" ist auf dem CAN Bus jedoch nicht vom Ruhe-Pegel zu unterscheiden. Andere Busteilnehmer können unter Umständen also nur indirekt erkennen, dass ein Busteilnehmer sich im Zustand "Error Passive" befindet.

Der Vorteil des hier vorgeschlagenen Verfahrens liegt demgegenüber darin, dass mit diesem Verfahren Busteilnehmer, die sich im Zustand "Error Passive" befinden, von den anderen Busteilnehmern eindeutig identifiziert werden können. Dies ist bisher über den Empfang eines "Passive Error Flags" nicht möglich. Den Zustand "Error Passive" kann in Busteilnehmern aus dem Stand der Technik nur der lokal am CAN-Controller angeschlossene Mikroprozessor erkennen und z.B. durch eine entsprechende Status-Nachricht den anderen Busteilnehmern mitteilen. Durch das neue Verfahren ist es für den Mikroprozessor nicht notwendig, eine Status-Nachricht zu versenden. Außerdem ist in diesem Fall die Information über den "Error Passive" Zustand zum Sende-Zeitpunkt aktuell, während der Zustand sich bei Versenden einer Status-Nachricht zwischen dem Erstellen der Status-Nachricht durch den Mikroprozessor und dem Sende-Zeitpunkt geändert haben kann.

In dem hier beschriebenen Verfahren wird die Information über den Zustand "Error Passive" eines Kommunikationscontrollers in die von dem Busteilnehmer ohnehin versandten Botschaften integriert. Hierzu wird das Control Field der Nachricht um ein weiteres Bit (ESI) erweitert. Dieses Bit wird, wie in Figur 1b dargestellt, nach der ersten Kennzeichnung (EDL) und vor dem DLC eingefügt, beispielsweise direkt vor oder direkt nach dem BRS-Bit. Ein Busteilnehmer, der sich im Zustand "Error Passive" befindet, sendet dieses Bit beispielsweise dominant, während andernfalls das Bit rezessiv gesendet wird. Eine umgekehrte Logik ist ebenfalls möglich.

Das vorgestellte Übertragungsverfahren eignet sich im normalen Betrieb eines Kraftfahrzeuges zur Übertragung von Daten zwischen wenigstens zwei Steuergeräten des Kraftfahrzeuges, welche über einen geeigneten Datenbus verbunden sind. Es ist aber gleichermaßen vorteilhaft einsetzbar während der Fertigung oder Wartung eines Kraftfahrzeuges zur Übertragung von Daten zwischen einer zum Zwecke der Programmierung mit einem geeigneten Datenbus verbundenen Programmierungseinheit und wenigstens einem Steuergerät des Kraftfahrzeuges, welches mit dem Datenbus verbunden ist.

Insgesamt stellt das Verfahren ein Übertragungsverfahren dar, welches sich dadurch auszeichnet, dass ein Norm-CAN Controller nur minimal geändert werden muss, um erfindungsgemäß arbeiten zu können. Ein erfindungsgemäßer Kommunikationscontroller, der auch als Norm-CAN Controller arbeiten kann, ist nur unwesentlich größer als ein herkömmlicher Norm-CAN Controller. Das zugehörige Anwendungs-Programm muss nicht geändert werden, und schon dann werden Vorteile in der Geschwindigkeit der Datenübertragung erzielt. Durch Verwendung der erweiterten Größe des Datenfeldes und der zugehörigen DLC und CRC kann die Geschwindigkeit der Datenübertragung weiter gesteigert werden, die Anpassungen in der Anwendungs-Software sind minimal. Es können weite Teile des CAN-Conformance-Tests (ISO 16845) übernommen werden. Es ist auch möglich, das erfindungsgemäße Übertragungsverfahren mit den Ergänzungen des TTCAN (ISO 11898-4) zu kombinieren.

## Patentansprüche

1. Verfahren zur seriellen Datenübertragung in einem Bussystem mit mindestens zwei Busteilnehmern, die über den Bus Nachrichten austauschen, wobei die gesendeten Nachrichten einen logischen Aufbau gemäß der CAN-Norm ISO 11898-1 aufweisen,
wobei der logische Aufbau ein Start-of-Frame-Bit, ein Arbitration Field, ein Control Field, ein Data Field, ein CRC Field, ein Acknowledge Field und eine End-of-Frame Sequenz umfasst,
wobei das Control Field einen Data Length Code umfasst, der eine Information über die Länge des Data Fields enthält,
**dadurch gekennzeichnet, dass** bei Vorliegen einer ersten Kennzeichnung (EDL) das Control Field der Nachrichten abweichend von der CAN-Norm ISO 11898-1 mehr als sechs Bit umfasst,
wobei bei Vorliegen der ersten Kennzeichnung (EDL) das Control Field der Nachricht um wenigstens ein weiteres Bit (ESI) erweitert wird,
wobei durch das weitere Bit (ESI) oder eines der weiteren Bits eine Information über den Zustand "Error Passive" des Busteilnehmers in versandte Botschaften integriert wird.

2. Verfahren nach Anspruch 1,
**dadurch gekennzeichnet, dass** bei Vorliegen der ersten Kennzeichnung (EDL) das Datenfeld der Nachrichten abweichend von der CAN-Norm ISO 11898-1 mehr als acht Bytes umfassen kann,
wobei zur Feststellung der Größe des Datenfeldes die Werte der vier Bits des Data Length Codes zumindest teilweise abweichend von der CAN-Norm ISO 11898-1 interpretiert werden.

3. Verfahren nach Anspruch 1 oder 2,
**dadurch gekennzeichnet, dass** bei Vorliegen einer zweiten Kennzeichnung (BRS) die Bitlänge für wenigstens einen vorgegebenen oder vorgebbaren Bereich innerhalb der Nachricht einen gegenüber der vor dem Vorliegen der zweiten Kennzeichnung verwendeten Bitlänge verkürzten Wert annimmt, wobei der Bereich frühestens mit der zweiten Kennzeichnung beginnt und spätestens mit dem CRC Delimiter endet,
wobei die zweite Kennzeichnung (BRS) nur bei Vorliegen der ersten Kennzeichnung (EDL) auftritt und in dem abweichend von der CAN-Norm ISO 11898-1 mehr als sechs Bit umfassenden Control Field der Nachrichten erfolgt.

4. Verfahren nach einem der Ansprüche 1 bis 3,
**dadurch gekennzeichnet, dass** die erste Kennzeichnung (EDL) durch ein rezessives Bit im Control Field erfolgt.

5. Verfahren nach einem der Ansprüche 1 bis 4,
**dadurch gekennzeichnet, dass** das weitere Bit (ESI) nach der ersten Kennzeichnung (EDL) und vor dem Data Length Code eingefügt wird.

6. Verfahren nach einem der Ansprüche 1 bis 5,
**dadurch gekennzeichnet, dass** bei Vorliegen der ersten Kennzeichnung auf das rezessive Bit der ersten Kennzeichnung (EDL) in allen Daten-Nachrichten wenigstens ein dominantes Bit folgt.

7. Verfahren nach einem der Ansprüche 2 bis 6,
**dadurch gekennzeichnet, dass** die zweite Kennzeichnung (BRS) durch ein rezessives Bit im Control Field erfolgt, welches zeitlich nach dem Bit der ersten Kennzeichnung (EDL) übertragen wird.

8. Verfahren nach Anspruch 7,
**dadurch gekennzeichnet, dass** bei Vorliegen der zweiten Kennzeichnung das rezessive Bit der zweiten Kennzeichnung (BRS) vom rezessiven Bit der ersten Kennzeichnung (EDL) durch wenigstens ein dominantes Bit getrennt ist.

9. Verfahren nach einem der Ansprüche 6 bis 8,
**dadurch gekennzeichnet, dass** bei Vorliegen der ersten Kennzeichnung die Flanke zwischen dem rezessiven Bit der ersten Kennzeichnung (EDL) und dem wenigstens einen folgenden dominanten Bit zur Re-Synchronisierung oder Hard-Synchronisierung des Bit-Timings der Busteilnehmer genutzt wird.

10. Verfahren nach einem der Ansprüche 1 bis 9,
**dadurch gekennzeichnet, dass** die erste Kennzeichnung (EDL) in den Busteilnehmern ausgewertet wird und abhängig von der ersten Kennzeichnung der Empfangsprozess an die Größe des Control Field und/oder des Datenfeldes und/oder nachfolgender Nachrichtenbestandteile angepasst wird.

11. Verfahren nach einem der Ansprüche 3 bis 10,
**dadurch gekennzeichnet, dass** die zweite Kennzeichnung (BRS) in den Busteilnehmern bei Vorliegen der ersten Kennzeichnung ausgewertet wird und abhängig vom Wert der zweiten Kennzeichnung der Empfangsprozess an die unterschiedlichen Werte der Bitlänge innerhalb einer Nachricht angepasst wird.

12. Verfahren nach einem der Ansprüche 3 bis 11,
**dadurch gekennzeichnet, dass** die mindestens zwei unterschiedlichen Werte der zeitlichen Bitlänge innerhalb einer Nachricht durch Verwendung mindestens zweier unterschiedlicher Skalierungsfaktoren zur Einstellung der Bus-Zeiteinheit relativ zu einer kleinsten Zeiteinheit oder dem Oszillatortakt im laufenden Betrieb realisiert werden.

13. Verfahren nach einem der Ansprüche 1 bis 12,
**dadurch gekennzeichnet, dass** bei Vorliegen einer weiteren Kennzeichnung das CRC Field der Nachrichten eine von der CAN Norm ISO 11898-1 abweichende Anzahl von Bits aufweist und / oder wenigstens ein von der CAN-Norm ISO 11898-1 abweichendes Generator-Polynom verwendet wird, wobei die weitere Kennzeichnung mit der ersten Kennzeichnung (EDL) übereinstimmen kann.

14. Verfahren nach Anspruch 13,
**dadurch gekennzeichnet, dass** der Wert der weiteren Kennzeichnung in den Busteilnehmern ermittelt wird und abhängig vom Wert der weiteren Kennzeichnung und / oder dem Inhalt des Data Length Code der Empfangsprozess an die Größe des CRC Field angepasst wird.

15. Verfahren nach einem der Ansprüche 13 bis 14,
**dadurch gekennzeichnet, dass** zu Beginn einer Nachricht die Berechnung von wenigstens zwei CRC Checksummen mittels unterschiedlicher Generator-Polynome parallel gestartet wird und abhängig vom Wert der weiteren Kennzeichnung entschieden wird, welches Ergebnis aus einer der parallel gestarteten CRC-Berechnungen verwendet wird.

16. Vorrichtung zur seriellen Datenübertragung in einem Bussystem mit mindestens zwei Busteilnehmern, die über den Bus Nachrichten austauschen, wobei die gesendeten Nachrichten einen logischen Aufbau gemäß der CAN-Norm ISO 11898-1 aufweisen,
wobei der logische Aufbau ein Start-of-Frame-Bit, ein Arbitration Field, ein Control Field, ein Data Field, ein CRC Field, ein Acknowledge Field und eine End-of-Frame Sequenz umfasst,
wobei das Control Field einen Data Length Code umfasst, der eine Information über die Länge des Data Fields enthält,
**dadurch gekennzeichnet, dass** bei Vorliegen einer ersten Kennzeichnung (EDL) das Control Field der Nachrichten abweichend von der CAN-Norm ISO 11898-1 mehr als sechs Bit umfasst,
wobei bei Vorliegen der ersten Kennzeichnung (EDL) das Control Field der Nachricht um wenigstens ein weiteres Bit (ESI) erweitert wird,
wobei durch das weitere Bit (ESI) oder eines der weiteren Bits eine Information über den Zustand "Error Passive" des Busteilnehmers in versandte Botschaften integriert wird.

17. Vorrichtung nach Anspruch 16,
**dadurch gekennzeichnet, dass** bei Vorliegen der ersten Kennzeichnung (EDL) das Datenfeld der Nachrichten abweichend von der CAN-Norm ISO 11898-1 mehr als acht Bytes umfassen kann,
wobei zur Feststellung der Größe des Datenfeldes die Werte der vier Bits des Data Length Codes zumindest teilweise abweichend von der CAN-Norm ISO 11898-1 interpretiert werden.

18. Vorrichtung nach Anspruch 16 oder 17,
**dadurch gekennzeichnet, dass** bei Vorliegen einer zweiten Kennzeichnung (BRS) die Bitlänge für wenigstens einen vorgegebenen oder vorgebbaren Bereich innerhalb der Nachricht einen gegenüber der vor dem Vorliegen der zweiten Kennzeichnung verwendeten Bitlänge verkürzten Wert annimmt,
wobei der Bereich frühestens mit der zweiten Kennzeichnung beginnt und spätestens mit dem CRC Delimiter endet,
wobei die zweite Kennzeichnung (BRS) nur bei Vorliegen der ersten Kennzeichnung (EDL) auftritt und in dem abweichend von der CAN-Norm ISO 11898-1 mehr als sechs Bit umfassenden Control Field der Nachrichten erfolgt.

19. Vorrichtung nach einem der Ansprüche 16 bis 18,
**dadurch gekennzeichnet, dass** die Vorrichtung durch geeignete Mittel dafür eingerichtet ist, zumindest eines der Verfahren zur Datenübertragung gemäß der Ansprüche 4 bis 15 auszuführen.

20. Verwendung des Verfahrens nach einem der Ansprüche 1 bis 15 im normalen Betrieb eines Kraftfahrzeuges zur Übertragung von Daten zwischen wenigstens zwei Steuergeräten des Kraftfahrzeuges, welche über einen geeigneten Datenbus verbunden sind.

21. Verwendung des Verfahrens nach einem der Ansprüche 1 bis 15 während der Fertigung oder Wartung eines Kraftfahrzeuges zur Übertragung von Daten zwischen einer zum Zwecke der Programmierung mit einem geeigneten Datenbus verbundenen Programmierungseinheit und wenigstens einem Steuergerät des Kraftfahrzeuges, welches mit dem Datenbus verbunden ist.

## Claims

1. Method for serially transmitting data in a bus system having at least two bus subscribers which interchange messages via the bus,
the transmitted messages having a logical structure according to the ISO 11898-1 CAN standard,
the logical structure comprising a start-of-frame bit, an arbitration field, a control field, a data field, a CRC field, an acknowledge field and an end-of-frame sequence,
the control field comprising a data length code containing an item of information relating to the length of the data field,
**characterized in that,** when a first identification (EDL) is present, the control field of the messages comprises more than six bits in a manner differing from the ISO 11898-1 CAN standard,
the control field of the message being extended with at least one further bit (ESI) when the first identification (EDL) is present,
an item of information relating to the "Error Passive" state of the bus subscriber being integrated in transmitted messages by means of the further bit (ESI) or one of the further bits.

2. Method according to Claim 1,
**characterized in that,** when the first identification (EDL) is present, the data field of the messages may comprise more than eight bytes in a manner differing from the ISO 11898-1 CAN standard,
in which case, in order to determine the size of the data field, the values of the four bits of the data length code are interpreted in a manner at least partially differing from the ISO 11898-1 CAN standard.

3. Method according to Claim 1 or 2,
**characterized in that,** when a second identification (BRS) is present, the bit length for at least one predefined or predefinable area inside the message assumes a value which is shortened in comparison with the bit length used before the presence of the second identification,
the area beginning at the earliest with the second identification and ending at the latest with the CRC delimiter,
the second identification (BRS) occurring only when the first identification (EDL) is present and being effected in the control field of the messages which comprises more than six bits in a manner differing from the ISO 11898-1 CAN standard.

4. Method according to one of Claims 1 to 3,
**characterized in that** the first identification (EDL) is effected by means of a recessive bit in the control field.

5. Method according to one of Claims 1 to 4,
**characterized in that** the further bit (ESI) is inserted after the first identification (EDL) and before the data length code.

6. Method according to one of Claims 1 to 5,
**characterized in that,** when the first identification is present, the recessive bit of the first identification (EDL) is followed by at least one dominant bit in all data messages.

7. Method according to one of Claims 2 to 6,
**characterized in that** the second identification (BRS) is effected by means of a recessive bit in the control field, which bit is transmitted temporally after the bit of the first identification (EDL).

8. Method according to Claim 7,
**characterized in that,** when the second identification is present, the recessive bit of the second identification (BRS) is separated from the recessive bit of the first identification (EDL) by at least one dominant bit.

9. Method according to one of Claims 6 to 8,
**characterized in that,** when the first identification is present, the edge between the recessive bit of the first identification (EDL) and the at least one following dominant bit is used for the resynchronization or hard synchronization of the bit timing of the bus subscribers.

10. Method according to one of Claims 1 to 9,
**characterized in that** the first identification (EDL) is evaluated in the bus subscribers and the receiving process is adapted to the size of the control field and/or the data field and/or subsequent message parts depending on the first identification.

11. Method according to one of Claims 3 to 10,
**characterized in that** the second identification (BRS) is evaluated in the bus subscribers when the first identification is present and the receiving process is adapted to the different values of the bit length inside a message depending on the value of the second identification.

12. Method according to one of Claims 3 to 11,
**characterized in that** the at least two different values of the temporal bit length inside a message are implemented during ongoing operation by using at least two different scaling factors for setting the bus time unit relative to a smallest time unit or the oscillator clock.

13. Method according to one of Claims 1 to 12,
**characterized in that,** when a further identification is present, the CRC field of the messages has a number of bits differing from the ISO 11898-1 CAN standard and/or at least one generator polynomial differing from the ISO 11898-1 CAN standard is used, the further identification being able to match the first identification (EDL).

14. Method according to Claim 13,
**characterized in that** the value of the further identification is determined in the bus subscribers and the receiving process is adapted to the size of the CRC field depending on the value of the further identification and/or the content of the data length code.

15. Method according to either of Claims 13 and 14,
**characterized in that,** at the beginning of a message, the calculation of at least two CRC checksums is started in a parallel manner using different generator polynomials and, depending on the value of the further identification, a decision is made regarding which result from one of the CRC calculations started in a parallel manner is used.

16. Apparatus for serially transmitting data in a bus system having at least two bus subscribers which interchange messages via the bus,
the transmitted messages having a logical structure according to the ISO 11898-1 CAN standard,
the logical structure comprising a start-of-frame bit, an arbitration field, a control field, a data field, a CRC field, an acknowledge field and an end-of-frame sequence,
the control field comprising a data length code containing an item of information relating to the length of the data field,
**characterized in that,** when a first identification (EDL) is present, the control field of the messages comprises more than six bits in a manner differing from the ISO 11898-1 CAN standard,
the control field of the message being extended with at least one further bit (ESI) when the first identification (EDL) is present,
an item of information relating to the "Error Passive" state of the bus subscriber being integrated in transmitted messages by means of the further bit (ESI) or one of the further bits.

17. Apparatus according to Claim 16,
**characterized in that,** when the first identification (EDL) is present, the data field of the messages may comprise more than eight bytes in a manner differing from the ISO 11898-1 CAN standard,
in which case, in order to determine the size of the data field, the values of the four bits of the data length code are interpreted in a manner at least partially differing from the ISO 11898-1 CAN standard.

18. Apparatus according to Claim 16 or 17,
**characterized in that,** when a second identification (BRS) is present, the bit length for at least one predefined or predefinable area inside the message assumes a value which is shortened in comparison with the bit length used before the presence of the second identification,
the area beginning at the earliest with the second identification and ending at the latest with the CRC delimiter,
the second identification (BRS) occurring only when the first identification (EDL) is present and being effected in the control field of the messages which comprises more than six bits in a manner differing from the ISO 11898-1 CAN standard.

19. Apparatus according to one of Claims 16 to 18,
**characterized in that** the apparatus is set up, by means of suitable means, to carry out at least one of the methods for transmitting data according to Claims 4 to 15.

20. Use of the method according to one of Claims 1 to 15 during normal operation of a motor vehicle for transmitting data between at least two control devices of the motor vehicle which are connected via a suitable data bus.

21. Use of the method according to one of Claims 1 to 15 during the production or maintenance of a motor vehicle for transmitting data between a programming unit connected to a suitable data bus for the purpose of programming and at least one control device of the motor vehicle which is connected to the data bus.

## Revendications

1. Procédé de transmission de données en série dans un système de bus comprenant au moins deux périphériques de bus qui échangent des messages par le biais du bus,
les messages envoyés possédant une structure logique conformément à la norme CAN ISO 11898-1,
la structure logique incluant un bit de début de trame, un champ d'arbitrage, un champ de commande, un champ de données, un champ CRC, un champ d'accusé de réception et une séquence de fin de trame,
le champ de commande incluant un code de longueur de données qui contient une information sur la longueur du champ de données,
**caractérisé en ce qu'**en présence d'une première identification (EDL), par dérogation à la norme CAN ISO 11898-1, le champ de commande des messages contient plus de six bits,
en présence de la première identification (EDL), le champ de commande étant élargi d'au moins un bit supplémentaire (ESI),
une information sur l'état « Error Passive » du périphérique de bus étant intégrée dans des messages envoyés au moyen du bit supplémentaire (ESI) ou d'un des bits supplémentaires.

2. Procédé selon la revendication 1, **caractérisé en ce qu'**en présence de la première identification (EDL), par dérogation à la norme CAN ISO 11898-1, le champ de données des messages peut contenir plus de huit octets,
les valeurs des quatre bits du code de longueur de données étant interprétées au moins partiellement par dérogation à la norme CAN ISO 11898-1 afin de définir la taille du champ de données.

3. Procédé selon la revendication 1 ou 2, **caractérisé en ce qu'**en présence d'une deuxième identification (BRS), la longueur des bits pour au moins une zone prédéfinie ou pouvant être prédéfinie à l'intérieur du message adopte une valeur raccourcie par rapport à la longueur des bits utilisée avant la présence de la deuxième identification,
la zone commençant au plus tôt avec la deuxième identification et se terminant au plus tard avec le délimiteur de CRC,
la deuxième identification (BRS) ne se produisant qu'en présence de la première identification (EDL) et étant effectuée dans le champ de commande des messages contenant plus de six bits par dérogation à la norme CAN ISO 11898-1.

4. Procédé selon l'une des revendications 1 à 3, **caractérisé en ce que** la première identification (EDL) s'effectue par un bit récessif dans le champ de commande.

5. Procédé selon l'une des revendications 1 à 4, **caractérisé en ce que** le bit supplémentaire (ESI) est inséré après la première identification (EDL) et avant le code de longueur de données.

6. Procédé selon l'une des revendications 1 à 5, **caractérisé en ce qu'**en présence de la première identification, au moins un bit dominant suit le bit récessif de la première identification (EDL) dans tous les messages de données.

7. Procédé selon l'une des revendications 2 à 6, **caractérisé en ce que** la deuxième identification (BRS) est effectuée par un bit récessif dans le champ de commande, lequel est transmis chronologiquement après le bit de la première identification (EDL).

8. Procédé selon la revendication 7, **caractérisé en ce qu'**en présence de la deuxième identification, le bit récessif de la deuxième identification (BRS) est séparé du bit récessif de la première identification (EDL) par au moins un bit dominant.

9. Procédé selon l'une des revendications 6 à 8, **caractérisé en ce qu'**en présence de la première identification, le front entre le bit récessif de la première identification (EDL) et l'au moins un bit dominant suivant est utilisé pour la resynchronisation ou la synchronisation forcée du rythme de bits des périphériques de bus.

10. Procédé selon l'une des revendications 1 à 9, **caractérisé en ce que** la première identification (EDL) est interprétée dans les périphériques de bus et le processus de réception est adapté, en fonction de la première identification, à la taille du champ de commande et/ou du champ de données et/ou des composants du message qui suivent.

11. Procédé selon l'une des revendications 3 à 10, **caractérisé en ce que** la deuxième identification (BRS) est interprétée dans les périphériques de bus dans le cas où la première identification est présente et le processus de réception est adapté, en fonction de la valeur de la deuxième identification, aux valeurs différentes des longueurs des bits à l'intérieur d'un message.

12. Procédé selon l'une des revendications 3 à 11, **caractérisé en ce que** les au moins deux valeurs différentes des longueurs de bits temporelles à l'intérieur d'un message sont réalisées en cours de fonctionnement en utilisant au moins deux facteurs d'échelle différents pour régler l'unité de temps du bus par rapport à une unité de temps la plus petite ou à l'horloge de l'oscillateur.

13. Procédé selon l'une des revendications 1 à 12, **caractérisé en ce qu'**en présence d'une identification supplémentaire, le champ CRC des messages présente un nombre de bits différent de celui de la norme CAN ISO 11898-1 et/ou au moins un polynôme générateur différent de celui de la norme CAN ISO 11898-1 est utilisé, l'identification supplémentaire pouvant coïncider avec la première identification (EDL).

14. Procédé selon la revendication 13, **caractérisé en ce que** la valeur de l'identification supplémentaire est déterminée dans les périphériques de bus et le processus de réception est adapté à la taille du champ CRC en fonction de la valeur de l'identification supplémentaire et/ou du contenu du code de longueur de données.

15. Procédé selon l'une des revendications 13 à 14, **caractérisé en ce qu'**au début d'un message, le calcul d'au moins deux sommes de contrôle CRC est démarré en parallèle au moyen de polynômes générateurs différents et, suivant la valeur de l'identification supplémentaire, il est décidé du résultat à utiliser parmi ceux des calculs CRC démarrés en parallèle.

16. Dispositif de transmission de données en série dans un système de bus comprenant au moins deux périphériques de bus qui échangent des messages par le biais du bus,
les messages envoyés possédant une structure logique conformément à la norme CAN ISO 11898-1,
la structure logique incluant un bit de début de trame,
un champ d'arbitrage, un champ de commande, un champ de données, un champ CRC, un champ d'accusé de réception et une séquence de fin de trame,
le champ de commande incluant un code de longueur de données qui contient une information sur la longueur du champ de données,
**caractérisé en ce qu'**en présence d'une première identification (EDL), par dérogation à la norme CAN ISO 11898-1, le champ de commande des messages contient plus de six bits,
en présence de la première identification (EDL), le champ de commande étant élargi d'au moins un bit supplémentaire (ESI),
une information sur l'état « Error Passive » du périphérique de bus étant intégrée dans des messages envoyés au moyen du bit supplémentaire (ESI) ou d'un des bits supplémentaires.

17. Dispositif selon la revendication 16, **caractérisé en ce qu'**en présence de la première identification (EDL), par dérogation à la norme CAN ISO 11898-1, le champ de données des messages peut contenir plus de huit octets,
les valeurs des quatre bits du code de longueur de données étant interprétées au moins partiellement par dérogation à la norme CAN ISO 11898-1 afin de définir la taille du champ de données.

18. Dispositif selon la revendications 16 ou 17, **caractérisé en ce qu'**en présence d'une deuxième identification (BRS), la longueur des bits pour au moins une zone prédéfinie ou pouvant être prédéfinie à l'intérieur du message adopte une valeur raccourcie par rapport à la longueur des bits utilisée avant la présence de la deuxième identification,
la zone commençant au plus tôt avec la deuxième identification et se terminant au plus tard avec le délimiteur de CRC,
la deuxième identification (BRS) ne se produisant qu'en présence de la première identification (EDL) et étant effectuée dans le champ de commande des messages contenant plus de six bits par dérogation à la norme CAN ISO 11898-1.

19. Dispositif selon l'une des revendications 16 à 18, **caractérisé en ce que** le dispositif est conçu, par des moyens appropriés, pour mettre en oeuvre au moins l'un des procédés de transmission de données selon les revendications 4 à 15.

20. Utilisation du procédé selon l'une des revendications 1 à 15 dans le fonctionnement normal d'un véhicule automobile pour la transmission de données entre au moins deux contrôleurs du véhicule automobile qui sont connectés par le biais d'un bus de données approprié.

21. Utilisation du procédé selon l'une des revendications 1 à 15 pendant la fabrication ou la maintenance d'un véhicule automobile pour la transmission de données entre une unité de programmation connectée à un bus de données approprié à des fins de programmation et au moins un contrôleur du véhicule automobile qui est connecté au bus de données.
